# EUROPEAN PATENT APPLICATION

(11) **EP 4 592 698 A1**
(43) Date of publication of application: **30.07.2025**
(21) Application number: 24382081.8
(22) Date of filing: 29.01.2024
(51) Int. Cl.: G01R 31/42, G01R 29/16

(54) **A METHOD FOR IDENTIFYING A DEFECT IN AN ELECTRICAL COMPONENT OF AN ENERGY INSTALLATION, GENERATOR UNIT, ENERGY INSTALLATION, COMPUTER-IMPLEMENTED METHOD AND COMPUTER PROGRAM PRODUCT**

(71) Applicant: Nordex Energy Spain, S.A.U., 31395 Barasoain (Navarra) (ES); Nordex Energy SE & Co. KG, 22419 Hamburg (DE)
(72) Inventor: Urkiaga Ezkurra, Josu, Barasoain (ES); Phan-Graebitz, Björn, Hamburg (DE); Dierck, Matthias, Hamburg (DE); Ortiz Irigoyen, Daniel, Barasoain (ES)
(74) Representative: Epping - Hermann - Fischer

(57) **Abstract**

A method (300) for identifying a defect in at least one electrical component of an energy installation (100) connected to an electrical grid (900) is specified, wherein the energy installation (100) comprises at least one generator unit (10) comprising at least one multiple-phase generator (11) configured for producing electrical energy and a multiple-phase local transformer (12) with a low-voltage side (121) and a high-voltage side (122) fed by the generator (11) on the low-voltage side (121), and wherein the method (300) comprises the steps for monitoring a local voltage asymmetry value on the low-voltage side (121) of the local transformer (12), and for comparing, in a first comparing step (33), the monitored local voltage asymmetry value to a predetermined threshold voltage asymmetry value.

Furthermore, a generator unit (10), an energy installation (100), a computer-implemented method (301) and a computer program product (302) are specified.

## Description

Embodiments of the present invention are related to a method for identifying a defect in an electrical component of an energy installation, preferably of an energy installation that comprises or is a power system like a power generating system, particularly preferably in the form of a multiple-phase system like a multiple-phase electrical energy-generating installation. Further embodiments are related to an energy installation comprising a generator unit and to a generator unit configured for being operated in an energy installation and for performing a method for identifying a defect in an electrical component of the energy installation. Further embodiments are related to a computer-implemented method and a computer program product.

A defect in an electrical component of an energy installation, for example a defect at an internal high-voltage winding of a transformer that is, for instance, connected to a wind turbine generator, can lead to a voltage asymmetry in a multiple-phase system. If such voltage asymmetry can be detected at a very early stage, the turbine can be stopped and de-energized for instance. Consequently, fatal damages to the transformer can be prevented.

At least one object of particular embodiments is to provide a method for identifying a defect in an electrical component of an energy installation. Further objects of particular embodiments are to provide a generator unit and an energy installation comprising a generator unit. Further objects of particular embodiments are to provide a computer-implemented method and a computer program product for performing the method for identifying a defect in at least one electrical component of an energy installation.

These objects are achieved by methods and subject-matters according to the independent claims. Advantageous embodiments and developments of the methods and the subject-matters are characterized in the dependent claims and are also disclosed by the following description and the drawings.

According to at least one embodiment, a method for identifying a defect in at least one electrical component of an energy installation is specified. According to at least one further embodiment, a generator unit is described. According to at least one further embodiment, an energy installation is specified. Preferably, the generator unit is a part of the energy installation, so that the energy installation comprises at least one generator unit. Accordingly, the at least one generator unit is operated in the energy installation. Particularly preferably, the generator unit is configured for performing a method for identifying a defect in at least one electrical component of the energy installation. That the energy installation comprises at least one generator unit can mean that the energy installation comprises exactly one generator unit or a plurality of generator units. Features and properties described in connection with a generator unit can apply to all generator units of the energy installation.

The features and embodiments described before and hereinafter equally apply to the method, to the generator unit, and to the energy installation.

According to a further embodiment, the method for identifying a defect in at least one electrical component of an energy installation is a computer-implemented method. In other words, a computer-implemented method is specified that can comprise one or more or all of the steps and features described herein in connection with the method for identifying a defect in at least one electrical component of an energy installation. Accordingly, the computer-implemented method comprises the method for identifying a defect in at least one electrical component of an energy installation.

According to a further embodiment, a computer program product is specified, the computer program product comprising instructions which, when the computer program product is executed by a computer or computer system, cause the computer or computer system to carry out the method for identifying a defect in at least one electrical component of an energy installation.

The features and embodiments described before and hereinafter in connection with the method for identifying a defect in at least one electrical component of an energy installation, the generator unit and the energy installation also apply to the computer-implemented method and the computer program product.

In particular, the energy installation can be connected to an electrical grid and can be configured to generate electrical energy and to provide the electrical energy to the electrical grid. In the energy installation, the at least one generator unit can be connected to a collector bus that is connected to the electrical grid. As described above, the energy installation can be or comprise a power system like a power generating system, preferably in the form of a multiple-phase system like a multiple-phase electrical energy-generating installation. For instance, the energy installation can be or comprise a wind farm comprising one or, preferably, a plurality of wind turbines.

According to a further embodiment, the at least one generator unit comprises at least one multiple-phase generator, hereinafter also referred to as "generator" for short, configured for producing electrical energy. The generator can be coupled to a turbine that drives the generator to generate electrical energy. In case of a wind farm, each generator unit can comprise at least one wind turbine coupled to a generator. Wind turbines are well known in the art and are used to generate energy by converting wind energy into electrical energy by means of wind turbine rotor blades coupled to a multiple-phase generator. In case the energy installation comprises more than one generator unit the generator units can comprise wind turbines that are similar or different from each other.

According to a further embodiment, the at least one generator unit comprises a multiple-phase local transformer, hereinafter also referred to as "local transformer" for short, with a low-voltage side and a high-voltage side. The local transformer is fed by the generator on the low-voltage side. In other words, the generator of the generator unit is connected to the low-voltage side of the local transformer.

According to a further embodiment, a local voltage asymmetry value is monitored in the at least one generator unit. Above and in the following, the expression "multiple-phase" can denote, for instance, three phases, so that the energy installation can preferably be a three-phase power system. Although the description in the following mainly refers to a three-phase system, other numbers of phases are also possible. A multiple-phase system is called balanced or symmetrical if the multiple-phase voltages and currents have the same amplitude and are equally phase shifted with respect to each other. Consequently, a three-phase system is called balanced or symmetrical if the three-phase voltages and currents have the same amplitude and are phase shifted by 120° with respect to each other. If one or both of these balance conditions are not met, the system is called unbalanced or asymmetrical. In order to quantify a balance in voltage or current of a multiple-phase system, so-called Fortescue or symmetrical components are used that consist of positive-, negative-, and zero-sequence quantities. The concept of the Fortescue components is well-known in the art and therefore only shortly summarized here: Positive-sequence quantities are those present during balanced conditions. Positive sequence quantities make up the normal voltages and currents observed on power systems during typical, steady-state conditions. Negative-sequence quantities can be a measure of the amount of unbalance existing on a power system. Zero-sequence quantities are most commonly associated with ground being involved in an unbalanced condition. Negative- and zero-sequence quantities are usually only present in substantial levels during unbalanced, faulted conditions on a power system, so that they can be used to determine a faulted condition on the power system. In particular, negative-sequence can be used to detect phase-to-phase, phase-to-ground, and phase-to-phase-to-ground faults, whereas zero-sequence quantities can be used to detect phase-to-ground and phase-to-phase-to-ground faults. Consequently, any voltage asymmetry value described herein like, for instance, the local voltage asymmetry value, can comprise negative- and/or zero-sequence quantities. Particularly preferably, a voltage asymmetry value described herein can comprise or be the ratio of the negative sequence quantity and the nominal voltage.

In particular, the local voltage asymmetry value can be monitored on the low-voltage side of the multiple-phase local transformer. In particular, the local voltage asymmetry value can be monitored in the at least one generator unit between the multiple-phase generator and the multiple-phase local transformer. Furthermore, in a first comparing step, the monitored local voltage asymmetry value is compared to a predetermined threshold voltage asymmetry value.

If a defect occurs in the transformer, a non-zero local voltage asymmetry value can be detected. In order to rule out small variations in the multiple-phase voltages and currents that are not caused by defects, the predetermined threshold voltage asymmetry value is set as a trigger value that has to be exceeded by the monitored local voltage asymmetry value. The local voltage asymmetry value exceeding the predetermined threshold voltage asymmetry value can be a condition to be met in order trigger an alarm step for the at least one generator unit. In particular, the local voltage asymmetry value exceeding the predetermined threshold voltage asymmetry value can be a first condition of more than one condition to be met in order to trigger an alarm step.

For example, in case the local voltage asymmetry value is, as described above, the ratio of the negative sequence quantity and the nominal voltage, a local voltage asymmetry value of 1/3, i.e. of about 33%, can indicate a complete failure of one phase. The predetermined threshold voltage asymmetry value can be greater than 0% or greater than 1% or greater than 2% and equal to or less than 100% or less than 50% or less than 10% or less than 5%. Preferably, the predetermined threshold voltage asymmetry value is set to be 3%.

For example, the at least one electrical component in which a defect is identified by the method described herein can comprise or be the local transformer. In other words, the method can be used for identifying a defect in the local transformer of the at least one generator unit. Furthermore, the at least one generator unit can be connected to the electrical grid via an intermediate electrical network comprising a collector bus. The at least one electrical component in which a defect is identified by the method described herein can comprise or be a part of the intermediate electrical network. In other words, the method can also be used for identifying a defect in the intermediate electrical network, for example in a cable.

In order to perform the method described herein, the at least one generator unit can comprise a monitoring device configured for monitoring the local voltage asymmetry value on the low-voltage side of the local transformer of the at least one generator unit. Furthermore, the at least one generator unit can comprise a computational device configured for comparing the measured local voltage asymmetry value to the predetermined voltage asymmetry threshold value. Consequently, the first comparing step can be performed by the at least one generator unit. The monitoring device and the computational device can be discrete electrical components or can be realized in the same electrical component. For instance, the at least one generator unit can comprise, as the monitoring device, a multifunctional device that is configured for monitoring a plurality of electrical quantities that include the balance conditions and, thus, the local voltage asymmetry value of the local transformer on its low-voltage side.

Furthermore, the generator unit can comprise a programmable logic controller that is a generator unit controller and that is configured for controlling the generator unit. The first comparing step can be carried out by the programmable logic controller serving as computational device.

Furthermore, any device or component described herein as performing one or more steps of the method for identifying a defect in at least one electrical component of an energy installation can be part of a computer. Accordingly, a computer can comprise one or more monitoring devices and/or one or more programmable logic controllers as described herein. Furthermore, the computer can comprise additional programmable components configured for performing one or more functions chosen form communicating, controlling, monitoring and data processing in regard to one or more or all components of the energy installation.

According to a further embodiment, the energy installation further comprises a grid-side multiple-phase main transformer. The main transformer can, in particular, be connected, on a low-voltage side, to a high-voltage side of the local transformer of the at least one generator unit, and, on a high-voltage side, to the electrical grid. The method can comprise a step in which a grid-side voltage asymmetry value on the low-voltage side or on the high-voltage side of the main transformer is monitored. For instance, the energy installation can comprise, as monitoring device, a multifunctional device that is configured for monitoring a plurality of electrical quantities that include the balance conditions, i.e. the local voltage asymmetry value, of the main transformer on its low-voltage side or on its high-voltage side.

Furthermore, in a second comparing step, the local voltage asymmetry value of the at least one generator unit can be compared to the grid-side voltage asymmetry value. The second comparing step can be performed by the computational device of the at least one generator unit. Accordingly, the grid-side voltage asymmetry value can be transmitted to the computational device of the at least one generator unit. Particularly preferably, the grid-side voltage asymmetry value is a weighted grid-side voltage asymmetry value that is obtained by multiplying the monitored grid-side voltage asymmetry value by a predetermined factor. Multiplying the monitored grid-side voltage asymmetry value with said factor and, thus, using the weighted grid-side voltage asymmetry value can be advantageous in connection with distinguishing a normal operating condition from a failure condition, since said factor can be understood as a safety factor that helps to avoid misinterpretation and unwanted triggering. The predetermined factor can be equal to or greater than 1.2 and equal to or less than 2. Preferably, the predetermined factor can be 1.5. In the following, the phrase "grid-side voltage asymmetry value" can refer to the unweighted or weighted grid-side voltage asymmetry value. The second comparing step can be performed by the at least one generator unit, in particular by the computational unit of the at least one generator unit.

When the local voltage asymmetry value exceeds the predetermined threshold voltage asymmetry value and when the local voltage asymmetry value exceeds the grid-side voltage asymmetry value, an alarm step can be triggered for the at least one generator unit. Consequently, the local voltage asymmetry value exceeding the grid-side voltage asymmetry value can be a second condition to be met for executing the alarm step in addition to the first condition described above that the local voltage asymmetry value exceeds the predetermined threshold voltage asymmetry value.

According to a further embodiment, the alarm step is executed only when the local voltage asymmetry value exceeds the predetermined threshold voltage asymmetry value for a predetermined delay time and/or when the local voltage asymmetry value of the at least one generator unit exceeds the grid-side voltage asymmetry value for the predetermined delay time. Consequently, the first condition and/or the second condition are only met if the local voltage asymmetry value of the at least one generator unit exceeds the predetermined threshold voltage asymmetry value and/or the grid-side voltage asymmetry value for a time that is equal to or more than the predetermined delay time, so that short variations in the voltage or current symmetries that can be caused by other effects than a defect in the at least one electrical component do not immediately trigger the alarm step. The predetermined delay time can be equal to or greater than 400 milliseconds and equal to or less than 60 seconds.

Preferably, the predetermined delay time can be 400 milliseconds.

According to a further embodiment, the method can be configured for detecting a defect in at least one electrical component when the at least one generator unit is connected to the electrical grid. In particular, from the moment on when the at least one generator unit is being connected to the energy installation, an output power of the at least one generator unit is monitored and compared to a predetermined output power threshold in a third comparing step. The predetermined power threshold can be equal to or greater than 1% and equal to or less than 10% of the nominal power. Preferably, the predetermined power threshold can be 5% of the nominal power.

When the local voltage asymmetry value exceeds the predetermined threshold voltage asymmetry value and the measured output power exceeds the predetermined output power threshold for a predetermined observation time, an alarm step can be triggered. The predetermined observation time can be equal to or greater than 1 second and equal to or less than 60 seconds. Preferably, the predetermined observation time can be 10 seconds. In this case, the predetermined threshold voltage asymmetry value can be equal to or greater than 1% and equal to or less than 20% and, particularly preferably, 2%.

As described above, the at least one generator unit can comprise a turbine driving the generator. When an alarm step is triggered, the turbine can be stopped and/or the at least one generator unit can be electrically disconnected from the energy installation.

Further advantages, advantageous embodiments and further developments are revealed by the embodiments described below in connection with the figures, in which:
Figure 1 shows a schematic illustration of a wind turbine,
Figure 2 shows a schematic illustration of a generator unit according to an embodiment,
Figure 3 shows a schematic illustration of method steps of a method for identifying a defect in at least one electrical component of an energy installation, of a computer-implemented method comprising the method for identifying a defect in at least one electrical component of an energy installation and of a computer program product for carrying out the method for identifying a defect in at least one electrical component of an energy installation according to further embodiments,
Figure 4 shows a schematic illustration of an energy installation according to a further embodiment,
Figures 5 to 8 show schematic illustrations of method steps of the method for identifying a defect in at least one electrical component of an energy installation according to further embodiments.

In the embodiments and figures, identical, similar or identically acting elements are provided in each case with the same reference numerals. The elements illustrated and their size ratios to one another should not be regarded as being to scale, but rather individual elements, such as for example layers, components, devices and regions, may have been made exaggeratedly large to illustrate them better and/or to aid comprehension.

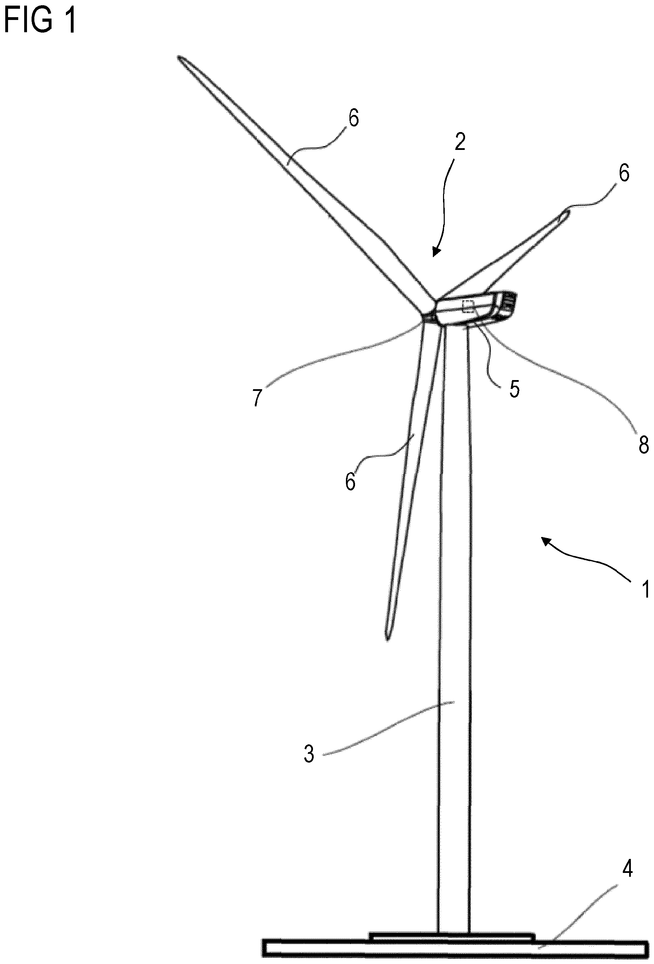

Figure 1 shows a wind turbine 1 which comprises a rotor 2 mounted to a tower 3. The tower 3 is fixed to the ground by means of a foundation 4. The rotor 2 comprises one or more (wind turbine) rotor blades 6, which are arranged on a rotor hub 7 mounted to a nacelle 5. The nacelle 5 is rotatably mounted at one end of the tower 3 opposite to the ground. The nacelle 5 houses, for example, a generator (not shown) which is coupled to the rotor 2 via a rotor shaft and, if necessary, a gearbox (not shown).

During operation, the rotor 2 is set in rotation by an air flow, for example wind. This rotational movement is transmitted to the generator via a drive train comprising, inter alia, the rotor shaft and, if necessary, the gearbox. The generator converts the mechanical energy of the rotor 2 into electrical energy.

For optimizing the energy output of the wind turbine 1, the nacelle 5 has to be rotated into the wind. Moreover, the pitch angles of the rotor blades 6 have to be set according to the wind speed. This is done with the help of drives (not shown) which rotate the rotor blades 6 and the nacelle 5 to a respective target position. In order to control and operate the drives, the wind turbine 1 comprises a wind turbine controller 8 comprising a drive control system which determines operating setpoints with which the drives are operated. As indicated in Figure 1, the wind turbine controller 8 can be located in the nacelle 5.

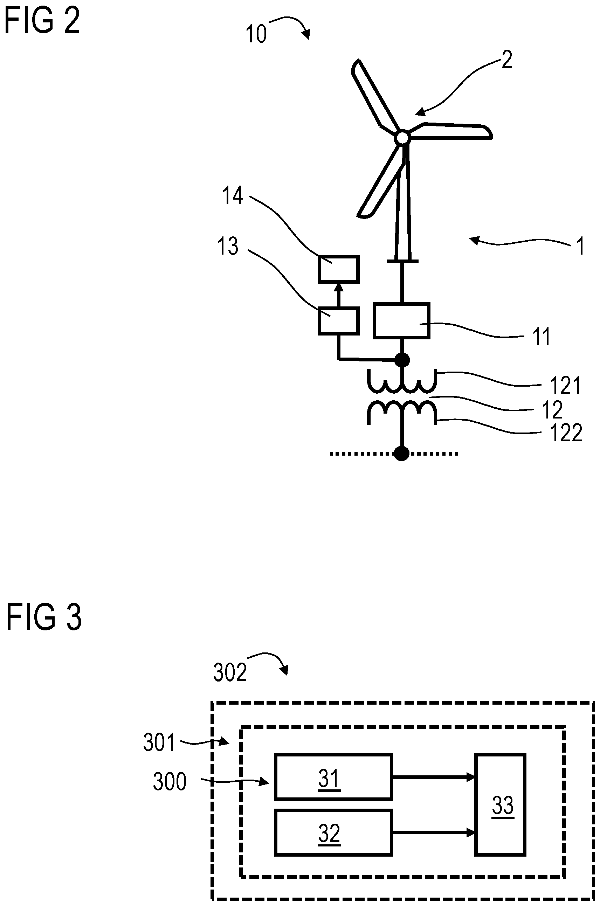

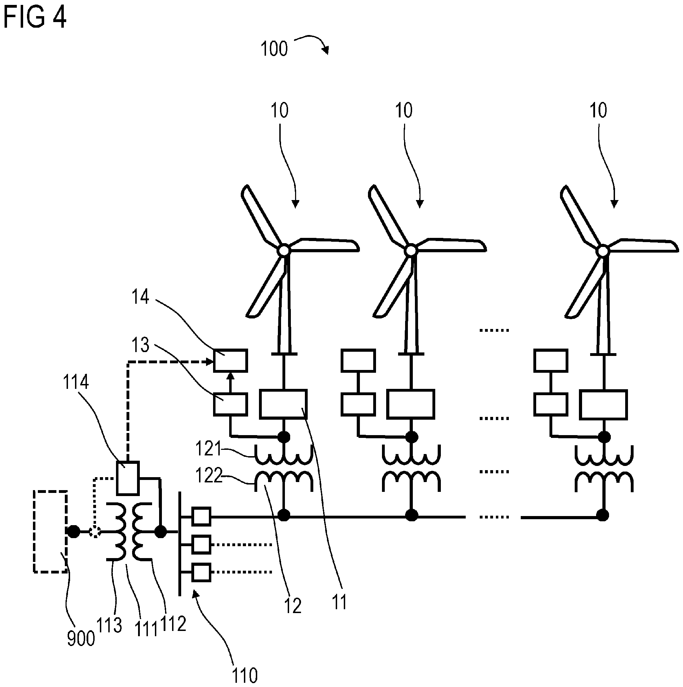

Figure 2 shows a schematic illustration of a generator unit 10 according to an embodiment. Here and in the following, the generator unit 10 comprises, by way of example, a wind turbine 1 with a wind-driven rotor 2 as explained in connection with Figure 1. However, other turbine types as for instance water-driven or steam driven turbines are also possible. The generator unit 10 can be a part of an energy installation as explained below in connection with Figure 4.

The generator unit 10 comprises at least one multiple-phase generator 11, hereinafter also "generator" for short, configured for producing electrical energy by converting mechanical energy provided by the rotor 2 into electrical energy as explained in connection with Figure 1. For the sake of clarity, the generator 11 is shown separately from the wind turbine 1. However, the generator 11 can preferably be located inside the nacelle 5 of the wind turbine 1 as described in connection with Figure 1 and, thus, can be a part of the wind turbine 1.

Furthermore, the generator unit 10 comprises a multiple-phase local transformer 12, hereinafter also "local transformer" for short, with a low-voltage side 121 and a high-voltage side 122. The generator 11 of the generator unit 10 is connected to the low-voltage side 121 of the local transformer 12, so that the local transformer 12 is fed by the generator 11 on the low-voltage side 121 and provides a higher voltage on the high-voltage side 122. The high-voltage side 122 can be connected to an electrical grid, for instance via a collector bus forming an intermediate electrical network, as explained in connection with Figure 4. The local transformer 12 can also be located in the nacelle or in another part of the wind turbine 1 or, alternatively, can be located separately from the wind turbine 1.

In particular, the generator 11 and the local transformer 12 can be three-phase devices that are usually used in power systems like wind farms that are configured for providing electrical energy to an electrical grid. However, other numbers of phases are also possible.

In order to detect defects in one or more electrical components of an energy installation that comprises at least one such generator unit 10, a method 300 for identifying a defect in at least one electrical component of an energy installation according to an embodiment is disclosed in connection with Figure 3. Particularly preferably, the generator unit 10 is configured for performing said method 300. Furthermore, the method 300 for identifying a defect in at least one electrical component of an energy installation can be a computer-implemented method 301 or can be a part of the computer-implemented method 301. Consequently, the computer-implemented method 301 can comprise or be the method 300 for identifying a defect in at least one electrical component of an energy installation as indicated in Figure 3. Moreover, the computer-implemented method 301 can be implemented in a computer program product 302 as also indicated in Figure 3, so that the computer program product 302 comprises instructions which, when the computer program product 302 is executed by a computer or computer system, cause the computer or computer system to carry out the method 300 for identifying a defect in at least one electrical component of an energy installation. Features and embodiments referring to the method 300 also apply to the computer-implemented method 301 and to the computer program product 302.

The method 300 comprises a method step 31 of monitoring a local voltage asymmetry value in the at least one generator unit 10. In a further step 32, a threshold voltage asymmetry value is predetermined. Moreover, in a method step 33 that will also be denoted as first comparing step 33 in the following, the monitored local voltage asymmetry value is compared to the predetermined threshold voltage asymmetry value.

As explained in the general part, a non-zero local voltage asymmetry value can be detected for instance when a defect occurs in the local transformer 12, so that said at least one electrical component in which a defect is identified by the method 300 can comprise or be the local transformer 12. The predetermined threshold voltage asymmetry value defines a trigger value that has to be exceeded by the monitored local voltage asymmetry value in the first comparing step 33 for triggering further steps in order to rule out small variations in the multiple-phase voltages and currents that are not caused by defects. If the monitored local voltage asymmetry value exceeds the predetermined threshold voltage asymmetry value, the first comparing step 33 outputs a positive first comparing result. In particular, in case the first comparing step 33 provides such positive first comparing result, the first comparing step 33 shown in Figure 3 can directly trigger an alarm step. Alternatively, the positive first comparing result that can be output by the first comparing step 33 can be one condition of at least two conditions that have to be fulfilled in order to trigger an alarm step for the at least one generator unit 10.

Preferably, the voltage asymmetry values of the embodiments described herein is, as described in the general part, the ratio of the negative sequence quantity and the nominal voltage. The predetermined threshold voltage asymmetry value predetermined in method step 32 can be greater than 0% or greater than 1% or greater than 2% and equal to or less than 100% or less than 50% or less than 10%or less than 5%. Preferably, the predetermined threshold voltage asymmetry value is set to be 3%.

In order to perform the method 300 described herein and thus, in order to also perform the method 301 and to execute the computer program product 302, the at least one generator unit 10 comprises, as further shown in Figure 2, a monitoring device 13 configured for monitoring the local voltage asymmetry value on the low-voltage side 121 of the local transformer 12 of the generator unit 10 in method step 31. Furthermore, the generator unit 10 comprises a computational device 14 configured for comparing the measured local voltage asymmetry value to the predetermined voltage asymmetry threshold value in method step 33. Consequently, the first comparing step 33 is preferably carried out by the at least one generator unit 10. The monitoring device 11 and the computational device 12 can be discrete electrical components or can be part of the same electrical component, such as an integrated electronic device. For instance, the at least one generator unit 10 can comprise, as monitoring device 13, a multifunctional device that is configured for monitoring a plurality of electrical quantities including the balance conditions and, thus, the local voltage asymmetry value of the local transformer 12 on its low-voltage side 121. Furthermore, the generator unit 10 can comprise a programmable logic controller that is a generator unit controller, for instance like the wind turbine controller 8 described in connection with Figure 1, and that is configured for controlling the generator unit 10. The first comparing step 33 can be carried out by the programmable logic controller serving as computational device 14. Consequently, the monitoring device 13 and the computational device 14 can be integrated in the wind turbine controller 8 described in Figure 1.

Particularly preferably, the monitoring device 13 and the computational device 14 as well as further devices and/or components described herein in connection with method steps of the method for identifying a defect in at least one electrical component of an energy installation can be part of a computer or a computer system, which includes a system with decentralized electronic components that are locally distributed over the energy installation that comprises the generator unit 10. Accordingly, said computer or computer system can comprise one or more multifunctional devices and/or one or more programmable logic controllers as described herein. Furthermore, the computer or computer system can comprise additional programmable components configured for performing one or more functions chosen from communicating, controlling, monitoring and data processing in regard to one or more or all components of the energy installation.

Figure 4 shows a schematic illustration of an energy installation 100 according to a further embodiment. The energy installation 100 comprises at least one generator unit 10 as explained above in connection with Figure 2. The at least one generator unit 10 is operated in the energy installation 100. In particular, the energy installation 100 can comprise a plurality of generator units 10 as indicated in Figure 4. Alternatively, the energy installation 100 can comprise exactly one generator unit 10. For the sake of clarity, the components of only one of the generator units 10 is provided with reference signs in Figure 4.

The generator units 10 can comprise wind turbines 1 that can be similar or different from each other. However, the features and embodiments explained above in connection with Figures 2 and 3 and hereinafter in connection with the following figures are preferably similar for all generator units 10. Consequently, description in the following that refers to one generator unit 10 applies to all generator units 10 of the energy installation 100. In particular, the method 300 described before and in the following is carried out individually by each of the generator units 10 of the energy installation 100.

The energy installation 100 is connected to an electrical grid 900, which is indicated by a dashed box in Figure 4 and which is no part of the energy installation 100. The energy installation 100 is configured to generate electrical energy that can be provided to the electrical grid 900. The generator units 10 are connected to an intermediate electrical network comprising a collector bus 110 that is connected to the electrical grid 900. In particular, the energy installation 100 can be or comprise a power system like a power generating system, preferably in the form of a multiple-phase system like a multiple-phase electrical energy-generating installation. Particularly preferably, as indicated in Figure 4, the energy installation 100 can be or comprise a wind farm. As indicated by the dotted lines, several groups comprising a respective plurality of generator units 10 can be coupled via the collector bus 110. Furthermore, each of the generator units 10 can comprise a switchgear (not shown), so that the generator unit 10 and, thus, the wind turbine 1 can be electrically connected to and disconnected from the energy installation 100 and, thus, the electrical grid 900. The switchgear can be located, for example, in the wind turbine 1 and can comprise protection devices like circuit breakers and cable switches.

The energy installation 100 further comprises a grid-side multiple-phase main transformer 111. The main transformer 111 is connected, on a low-voltage side 112, to a high-voltage side of the local transformers 122 of the generator units 10 via the collector bus 110. On a high-voltage side 113, the main transformer 111 is connected to the electrical grid 900.

Furthermore, the energy installation 100 comprises a monitoring device 114 for monitoring a grid-side voltage asymmetry value on the low-voltage side 112 or, as indicated by the dotted lines, on the high-voltage side 113 of the main transformer 111. For instance, the monitoring device 114 can be a multifunctional device that is configured for monitoring a plurality of electrical quantities that include the balance conditions, i.e. the voltage asymmetry value, of the main transformer 111 on its low-voltage side 112 or on its high-voltage side 113.

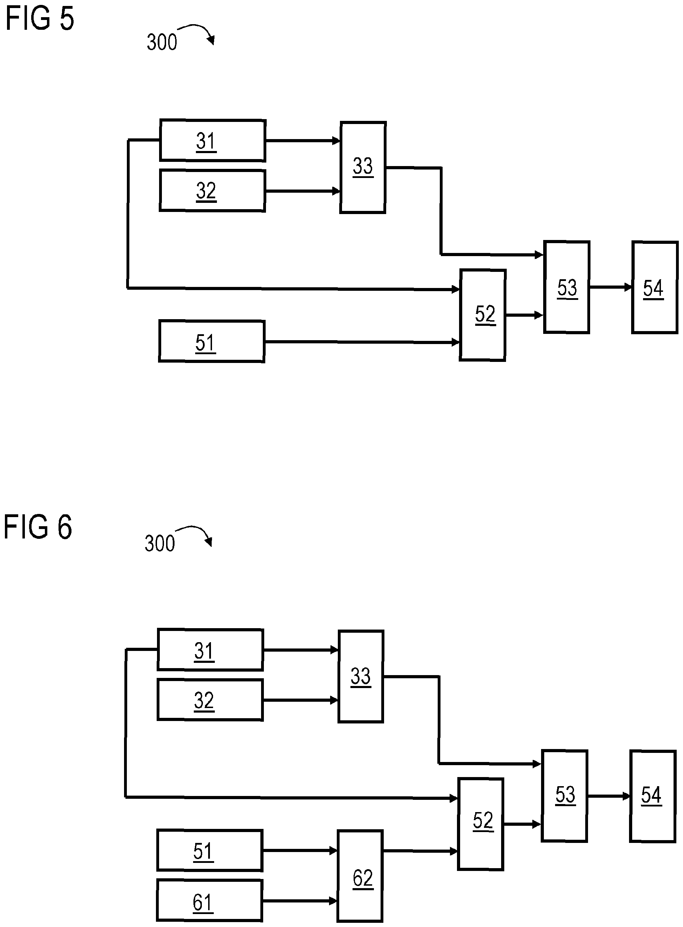

Figures 5 to 8 show schematic illustrations of method steps of further embodiments and developments of the method 300 described above. Although not explicitly indicated, the method 300 according to the embodiments and further developments described hereinafter can be comprised by the computer-implemented method 301 and by the computer program product 302. Descriptions of parts of the generator unit 10 and the energy installation 100 hereinafter refer to Figures 2 and 4.

As indicated in Figure 5, according to a further embodiment the method 300 can comprise, in addition to the method steps described in connection with Figure 3, a method step 51 in which a grid-side voltage asymmetry value on the low-voltage side 112 or on the high-voltage side 113 of the main transformer 111 is monitored. Method step 51 can be performed by the monitoring device 114 that can be or comprise a multifunctional device that is configured for monitoring a plurality of electrical quantities that include the grid-side voltage asymmetry value of the main transformer 111 on its low-voltage side 112 or on its high-voltage side 113.

Furthermore, in a further method step 52, which is also denoted as second comparing step 52 hereinafter, the local voltage asymmetry value of the generator unit 10 that is monitored in step 31 is compared to the grid-side voltage asymmetry value that is monitored in step 51. The second comparing step 52 can be performed by the computational device 14 of the generator unit 10 as indicated in Figure 4. Accordingly, the grid-side voltage asymmetry value can be transmitted to the computational device 14 of each of the generator units 10. If the monitored local voltage asymmetry value exceeds the monitored grid-side voltage asymmetry value, the second comparing step 52 outputs a positive second comparing result.

The results provided by the first comparing step 33 and the result of the second comparing step 52 are investigated in a further method step 53 by the computational device 14 of the generator unit 10. When the first comparing step 33 provides a positive first comparing result and when the second comparing step 52 provides a positive second comparing result, method step 53 can trigger a further method step 54 that can be an alarm step for the generator unit 10. Method step 53 can be carried out by the computational device 14 of the generator unit 10. For instance, the alarm step can result in stopping the wind turbine of the generator unit and/or electrically disconnecting the wind turbine and, thus, the generator unit, from the collector bus and, thus, from the energy installation.

For example, the grid-side voltage asymmetry value can be passed through from a wind farm controller of the energy installation 100 to each of the generator units 10, i.e. to the wind turbine controller 8 of each of the generator units 10 and, thus, to the computational device 14 of each of the generator units 10. In case the energy installation 100 comprises more than one multifunctional device as the monitoring device 114, preferably the one used for wind farm control is used to forward the grid-side voltage asymmetry value. In case the monitoring device 114 is connected to a master wind farm controller, the grid-side voltage asymmetry value is passed through the wind farm controller to the generator units 10.

Particularly preferably, the grid-side voltage asymmetry value provided for the second comparing step 52 is a weighted grid-side voltage asymmetry value. As shown in a further development of the method 300 in Figure 6, a predetermined factor can be provided in an additional method step 61. The weighted grid-side voltage asymmetry value can be obtained by multiplying the monitored grid-side voltage asymmetry value obtained in method step 51 by the predetermined factor of method step 61 in a further method step 62. The result of method step 62 is then provided as the grid-side voltage asymmetry value for the second comparing step 52. Thus, the phrase "grid-side voltage asymmetry value" used herein can refer to the unweighted grid-side voltage asymmetry value or to the weighted grid-side voltage asymmetry value depending of the embodiment of method 300. The predetermined factor can be equal to or greater than 1.2 and equal to or less than 2. Preferably, the predetermined factor can be 1.5. The method steps 61 and 62 can be performed, for instance, by the wind farm controller or, preferably, by each of the generator units 10 and, thus, by the computational devices 14 of the generator units 10.

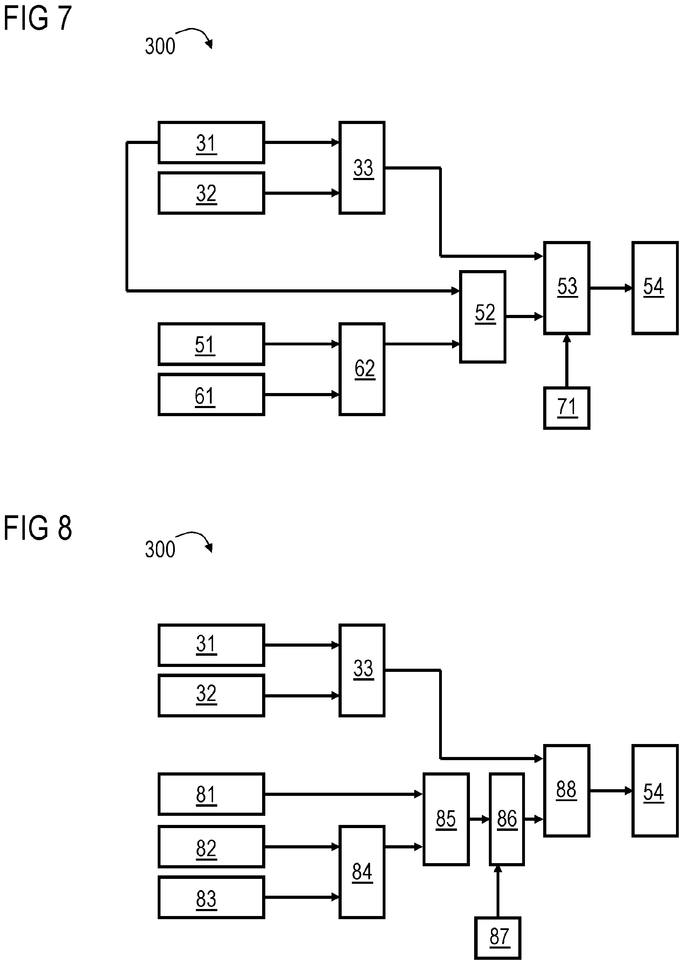

According to a further development of method 300 that is shown in Figure 7, the alarm step of method step 54 is triggered by method step 53 only when the first comparing step 33 provides a positive first comparing result and/or when the second comparing step 52 provides a positive second comparing result for a predetermined delay time that is provided in a method step 71. Consequently, the first condition and/or the second condition are only fulfilled if the local voltage asymmetry value of the at least one generator unit exceeds the predetermined threshold voltage asymmetry value and/or the grid-side voltage asymmetry value for a time that is equal to or more than the predetermined delay time. Preferably, both the first and second condition must be fulfilled for the predetermined delay time in order to trigger an alarm step. The predetermined delay time can be equal to or greater than 400 milliseconds and equal to or less than 60 seconds. Preferably, the predetermined delay time is 400 milliseconds.

As explained in connection with Figures 5 to 7, in case the monitored local voltage asymmetry value in a generator unit 10 is greater than the predetermined threshold voltage asymmetry value and in case the monitored local voltage asymmetry value in that generator unit 10 is greater than the grid-side voltage asymmetry value, optionally multiplied by a certain factor for a certain delay and further optionally for a predetermined delay time, an alarm is triggered and the turbine stops, optionally with collector bus disconnection from the generator unit 10.

Figure 8 shows a further embodiment of the method 300 comprising method steps 81 to 88 that can be carried out independent from the embodiments described in connection with Figures 5 to 7, particularly when the generator unit 10 is being electrically connected to the electrically grid 900. In other words, the method steps 81 to 88 are configured for detecting a defect in at least one electrical component when a generator unit 10 is just being connected to the electrical grid 900. In particular, from the moment on when the generator unit 10 is being electrically connected to the energy installation 100, an output power of the generator unit 10 is monitored and compared to a predetermined output power threshold in a third comparing step.

Consequently, in a method step 81 it is monitored whether the generator unit 10 is being electrically connected to the energy installation 100. Method step 81 can be performed, for instance, by the monitoring device 13 of the generator unit 10. Furthermore, the output power of the generator unit 10 is monitored, for instance also by the monitoring device 13, in a further method step 82, and the predetermined output power threshold is provided in a further method step 83. The predetermined power threshold can be equal to or greater than 1% and equal to or less than 10% of the nominal power. Preferably, the predetermined power threshold can be 5% of the nominal power.

The above-mentioned third comparing step of comparing the monitored output power and the predetermined output power threshold is represented by method step 84. If the monitored output power exceeds the predetermined output power threshold, the third comparing step 84 outputs a positive third comparing result. In a further method step 85 it is investigated whether the third comparing step 84 provides a positive third comparing result and whether method step 81 provides the result that the generator unit 10 is being electrically connected to the electrical grid. The investigation of said both conditions is carried out for a predetermined observation time, represented by method step 86, wherein the predetermined observation time is provided in a further method step 87. In a further method step 88 it is investigated whether, in addition to a positive result in method step 86, the first comparing step 33 provides a positive first comparing result. In case both conditions are found to be fulfilled in method step 88, an alarm step 54 as described above can be triggered by method step 88. The predetermined observation time can be equal to or greater than 1 second and equal to or less than 60 seconds. Preferably, the predetermined observation time can be 10 seconds. In this case, the predetermined threshold voltage asymmetry value can be equal to or greater than 1% and equal to or less than 20% and, particularly preferably, 2%. Preferably, method steps 84 to 88 are carried out by the computational device 14 of the generator unit 10. Consequently, when the local voltage asymmetry value exceeds the predetermined threshold voltage asymmetry value and the measured output power exceeds the predetermined output power threshold for a predetermined observation time right after the generator unit 10 has been electrically connected to the electrical grid, an alarm step can be triggered. In other words, if, after grid connection of a wind turbine and, thus, of the corresponding generator unit 10, the active power production exceeds a specific predetermined output power threshold and if then within a specific time range, given by the observation time, a local voltage asymmetry value is greater than a specific threshold, given by the predetermined threshold voltage asymmetry value, an alarm is triggered that can result in stopping that wind turbine and/or electrically disconnecting the wind turbine and, thus, the generator unit, from the collector bus and, thus, from the energy installation.

The embodiments of the method 300 described in connection with any of the Figures 5 to 7 can be combined with the embodiment described in connection with Figure 8.

As described above, the at least one electrical component in which a defect is identified by the method according to the various embodiments described herein can comprise or be the local transformer. Furthermore, the at least one electrical component in which a defect is identified by the method according to the embodiments described herein can comprise or be a part of the intermediate electrical network, so that the method according to the various embodiments described herein can also be used for identifying a defect in the intermediate electrical network, for example in a cable.

The method described herein can preferably be realized as a software solution, using existing protection devices usually present at wind farms. Consequently, there is no need of additional measurement devices and protection hardware, so that there is no additional cost impact to detect a defect in a transformer like, for instance, a high voltage winding damage, or in another component that causes a voltage asymmetry in a generator unit. Thus, no additional space is needed for instance within the switchgear of the generator units, which would be the case if additional external hardware devices were needed.

Thus, the invention described herein can provide the advantage that, for instance, the repair time for a defective local transformer can be minimized, because a simple repair can be done locally. In contrast, in case of a fatal transformer damage a new local transformer needs to be delivered. As a result, the invention provides the possibility that the standstill time of a wind turbine in case of a defective transformer as well as consequential liquidated damages can be minimized. In addition, possible collateral damages to the whole wind turbine electrical system can be prevented.

The features and embodiments described in connection with the figures can also be combined with one another, even if not all such combinations are explicitly described. Furthermore, the embodiments described in connection with the figures may have additional and/or alternative features according to the description in the general part.

The invention is not limited by the description based on the embodiments to these embodiments. Rather, the invention includes each new feature and each combination of features, which includes in particular each combination of features in the patent claims, even if this feature or this combination itself is not explicitly explained in the patent claims or embodiments.

### Reference signs

- 1: wind turbine
- 2: rotor
- 3: tower
- 4: foundation
- 5: nacelle
- 6: rotor blade
- 7: rotor hub
- 8: wind turbine controller
- 10: generator unit
- 11: generator
- 12: transformer
- 13: monitoring device
- 14: computational device
- 31, 32, 33: method step
- 51, 52, 53, 54: method step
- 61, 62: method step
- 71: method step
- 81, 82, 83, 84: method step
- 85, 86, 87, 88: method step
- 100: energy installation
- 110: collector bus
- 111: transformer
- 112: low-voltage side
- 113: high-voltage side
- 114: monitoring device
- 121: low-voltage side
- 122: high-voltage side
- 300: method
- 301: computer-implemented method
- 302: computer program product
- 900: grid

## Claims

1. A method (300) for identifying a defect in at least one electrical component of an energy installation (100) connected to an electrical grid (900), the energy installation (100) comprising:
- at least one generator unit (10) comprising at least one multiple-phase generator (11) configured for producing electrical energy and a multiple-phase local transformer (12) with a low-voltage side (121) and a high-voltage side (122) fed by the generator (11) on the low-voltage side (121),
wherein the method (300) comprises the following steps:
- monitoring a local voltage asymmetry value on the low-voltage side (121) of the local transformer (12),
- comparing, in a first comparing step (33), the monitored local voltage asymmetry value to a predetermined threshold voltage asymmetry value.

2. The method (300) according to claim 1, wherein the at least one electrical component comprises the local transformer (12) and/or a part of an intermediate electrical network which comprises a collector bus (110) and through which the at least one generator unit (10) is connected to the electrical grid (900).

3. The method (300) according to one of the preceding claims, wherein the energy installation (100) further comprises
- a grid-side multiple-phase main transformer (111) connected, on a low-voltage side (112), to a high-voltage side (122) of the local transformer (12) of the at least one generator unit (10), and connected, on a high-voltage side (113), to the electrical grid (900),
wherein the method (300) comprises the following further steps:
- monitoring a grid-side voltage asymmetry value on the low-voltage side (112) or on the high-voltage side (113) of the main transformer (111),
- comparing, in a second comparing step (52), the local voltage asymmetry value of the at least one generator unit (10) to the grid-side voltage asymmetry value.

4. The method (300) according to claim 3, wherein the grid-side voltage asymmetry value is a weighted grid-side voltage asymmetry value that is obtained by multiplying the monitored grid-side voltage asymmetry value by a predetermined factor.

5. The method (300) according to claim 3 or 4, wherein the first comparing step (33) and the second comparing step (52) are performed by the at least one generator unit (10) .

6. The method (300) according to one of the claims 3 to 5, wherein, when the local voltage asymmetry value exceeds the predetermined threshold voltage asymmetry value and when the local voltage asymmetry value exceeds the grid-side voltage asymmetry value, an alarm step is triggered for the at least one generator unit (10).

7. The method (300) according to claim 6, wherein the alarm step is executed only when the local voltage asymmetry value exceeds the predetermined threshold voltage asymmetry value for a predetermined delay time and/or when the local voltage asymmetry value of the at least one generator unit (10) exceeds the grid-side voltage asymmetry value for the predetermined delay time.

8. The method (300) according to one of the preceding claims, wherein, from the moment on when the at least one generator unit (10) is being connected to the energy installation (100), an output power of the at least one generator unit (10) is monitored and compared to a predetermined output power threshold in a third comparing step (84).

9. The method (300) according to claim 8, wherein, when the local voltage asymmetry value exceeds the predetermined threshold voltage asymmetry value and the measured output power exceeds the predetermined output power threshold for a predetermined observation time, an alarm step is triggered.

10. The method (300) according to one of the claims 5 to 7 and 9, wherein the at least one generator unit (10) further comprises a turbine (1) driving the generator (11) and, when an alarm step is triggered, the turbine (1) is stopped and/or the at least one generator unit (10) is electrically disconnected from the energy installation (100).

11. The method (300) according to one of the preceding claims, wherein the energy installation (100) is a wind farm.

12. A computer-implemented method (301), comprising the method (300) according to one of the preceding claims.

13. A computer program product (302) comprising instructions which, when the computer program product (302) is executed by a computer or computer system, cause the computer or computer system to carry out the method (300, 301) according to one of the preceding claims.

14. A generator unit (10) configured for being operated in an energy installation (100) and for performing a method (300) according to one of the claims 1 to 13, the generator unit (10) further comprising:
- a monitoring device (13) configured for monitoring the local voltage asymmetry value on the low-voltage side (121) of the local transformer (11) of the at least one generator unit (10),
- a computational device (14) configured for comparing the measured local voltage asymmetry value to a predetermined voltage asymmetry threshold.

15. Energy installation (100), comprising at least one generator unit (10) according to claim 14.
